Europäisches Patentamt

European Patent Office

Office européen des brevets

(19)

(11) Veröffentlichungsnummer: **0 024 305**
**B1**

(12) **EUROPÄISCHE PATENTSCHRIFT**

(45) Veröffentlichungstag der Patentschrift:
02.05.85

(51) Int. Cl.⁴: **C 23 C 16/34**, C 23 C 16/40,
H 01 L 21/316

(21) Anmeldenummer: 80104212.8

(22) Anmeldetag: 18.07.80

(54) Verfahren zum Aufbringen von SiO2-Filmen mittels chemischen Niederschlagens aus der Dampfphase.

(30) Priorität: 16.08.79 US 66964
16.08.79 US 66965

(73) Patentinhaber: International Business Machines
Corporation, Old Orchard Road, Armonk, N.Y. 10504 (US)

(43) Veröffentlichungstag der Anmeldung:
04.03.81 Patentblatt 81/9

(72) Erfinder: Kemlage, Bernard Michael, Route 1 Box 344A,
Kingston N.Y. 12401 (US)

(45) Bekanntmachung des Hinweises auf die Patenterteilung:
02.05.85 Patentblatt 85/18

(74) Vertreter: Oechssler, Dietrich, Dr. rer. nat., Schönaicher
Strasse 220, D-7030 Böblingen (DE)

(84) Benannte Vertragsstaaten:
AT DE FR GB

(56) Entgegenhaltungen:
CH - A - 474 858
DE - A - 1 614 540
DE - A - 1 696 607
DE - A - 1 717 205
DE - A - 1 771 538
DE - B - 2 538 300
FR - A - 2 190 946
GB - A - 1 147 412
GB - A - 1 413 261

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft Verfahren zum Aufbringen eines Siliciumdioxid-Films auf ein Substrat mittels chemischen Niederschlagens aus der Dampfphase in der heissen Zone des Ofens bei Temperaturen oberhalb etwa 800 °C und bei Drücken < 6,66 mbar, bei welchem ein Chlorsilan mit einem oxidierenden Stickstoffoxid zur Reaktion gebracht wird.

Siliciumdioxid wird in grossem Umfang als Material für Isolier- und/oder Maskenschichten bei der Bildung von integrierten Halbleiterschaltungen benutzt. Eine wichtige Methode, um Siliciumdioxid zu erzeugen, ist das thermische Aufwachsen von Siliciumdioxid, wobei das Silicium in der Gegenwart von Sauerstoff oder Dampf bei relativ hohen Temperaturen, d.h. bei Temperaturen oberhalb 900 °C und sehr häufig bei einer Temperatur von 1000 °C oder darüber, thermisch oxidiert wird. Das Verfahren gehört zu den Hochtemperaturprozessen. Bei solchen Prozessen kann eine Verschiebung von PN-Übergängen stattfinden. Ein weiteres Problem besteht darin, dass die Methode nur anwendbar ist, wenn das Siliciumdioxid auf Silicium aufgewachsen werden soll. Bei einer weiteren Methode zum Aufwachsen von Siliciumdioxidschichten wird mittels chemischen Niederschlagens aus der Dampfphase gearbeitet, wobei eine Oxidation von Siliciumtetrachlorid, Silan, Dichlorsilan oder ähnlichen Materialien im Gaszustand stattfindet. Diese Methode ist viele Jahre lang bei Atmosphärendruck durchgeführt worden. Erst seit kurzem werden bei diesem Verfahren niedrige Drücke in der Grössenordnung von weniger als 1,33 mbar angewandt.

Wird das Verfahren des chemischen Niederschlagens von Siliciumdioxid aus der Dampfphase bei Atmosphärendruck durchgeführt, wobei eine Oxidation von Siliciumtetrachlorid oder Silan in der Gasphase stattfindet, so erfordert dies im allgemeinen die Anwendung unerwünscht hoher Temperaturen, wie z.B. von Temperaturen zwischen 900 und 1200 °C. Bei diesen Temperaturen tritt das Problem einer Verschiebung von PN-Übergängen auf, welche unerwünscht ist. Bei der Oxidation von Silan oder Siliciumtetrachlorid in der Gasphase bei Temperaturen unter 900 °C werden Siliciumdioxid-Filme erhalten, welche schlechtere Eigenschaften als die thermisch gewachsenen Siliciumdioxid-Filme haben. Im US-Patent 4 002 512 wird ein Verfahren zur Herstellung von Siliciumdioxid-Filmen hoher Qualität bei niedriger Temperatur beschrieben, bei welchem Dichlorsilan eingesetzt wird, welches oxidiert wird mit einem oxidierenden Gas, wie z.B. $O_2$, $CO_2$, $N_2O$, $H_2O$ usw., das mit einem inerten Trägergas, wie z.B. He, Ar, $N_2$, $H_2$ usw. vermischt ist.

Die Anwendung eines heisse Wände aufweisenden Niederdrucksystems für das chemische Niederschlagen aus der Dampfphase von Siliciumdioxid ist beschrieben worden in einem Vortrag, den J. Sandor auf dem Elektro-Chemical Society Meeting in Los Angeles vom 6. bis 10. Mai 1962 gehalten hat, und in den Artikeln von J. Oroshnik, u.a. in der Zeitschrift Journal Electro-Chemical Society Solid State Science, Band 115, Seite 649, 1968 und von R.S. Rosler in der Zeitschrift Solid State Technology, April 1977, Seite 63 bis 70 (Title: «Low Pressure CVD Production Processes for Poly, Nitride, and Oxide»). Der Artikel von R.S. Rosler gibt einen Überblick über die verschiedenen Methoden des chemischen Niederschlagens aus der Dampfphase bei niedrigem Druck zum Aufbringen von Filmen aus polykristallinem Silicium, Siliciumnitrid und Siliciumdioxid in der Halbleiterindustrie. Auf Seite 68 beschreibt Rosler die Niederdruckreaktionen von Dichlorsilan und Distickstoffoxid im Temperaturbereich zwischen 800 und 920 °C.

Es ist gefunden worden, dass die im gasförmigen Zustand ablaufenden Reaktionen der Chlorsilane und insbesondere von Dichlorsilan mit Distickstoffoxid Siliciumdioxidschichten erzeugten, welche bezüglich ihres Brechensindexes von hoher Qualität waren, welche sich jedoch bei nachfolgenden Oxidationsbehandlungen in ihren Eigenschaften verschlechterten.

Es ist die Aufgabe der Erfindung, ein Verfahren anzugeben, um mittels chemischen Niederschlagens aus der Dampfphase bei niedrigem Druck, $SiO_2$-Filme hoher Qualität zu erzeugen, bei welchen nach Behandlungen unter oxidierenden Bedingungen bei hohen Temperaturen keine Bildung von Bläschen oder kleinen Erhebungen und/oder kein Abblättern von $SiO_2$ festgestellt wird.

Diese Aufgabe wird mit Verfahren der eingangs genannten Art mit den Merkmalen der kennzeichnenden Teile der Ansprüche 1 und 5 gelöst.

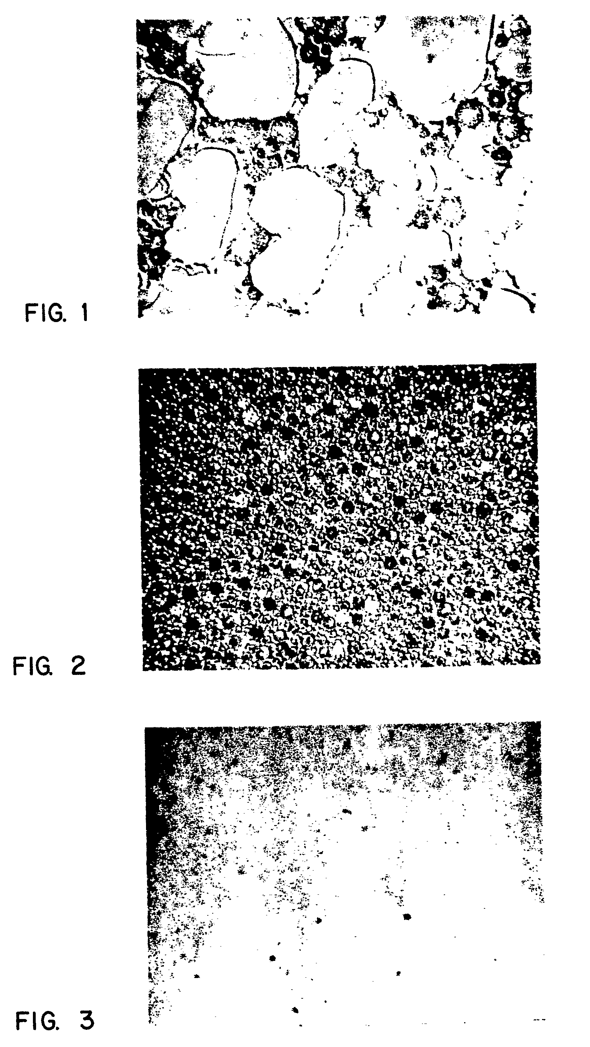

Offenbar ist es so, dass sich unter den mittels der bekannten Verfahren hergestellten $SiO_2$-Filme Unterhöhlungen bilden, welche die Ursache beispielsweise für das Abblättern von $SiO_2$ sind, welches insbesondere für die dickeren (> 250 nm) der bekannten Filme charakteristisch ist. Photographien von 216 mal vergrösserten Ausschnitten aus $SiO_2$-Filmen, welche durch die Behandlung unter oxidierenden Bedingungen verschlechtert worden sind, zeigen die Figuren 1 und 2 (zum Vergleich zeigt die Fig. 3 eine Photographie eines ebenfalls 216 mal vergrösserten Ausschnitts aus einem $SiO_2$-Film, welcher durch die Behandlung unter oxidierenden Bedingungen nicht verschlechtert worden ist). Dabei muss angemerkt werden, dass die in den Fign. 1 und 2 gezeigten Filme gemäss Verfahren hergestellt worden sind, welche günstigere Ergebnisse als die bekannten Verfahren liefern. Bei der Suche nach der Ursache für die Verschlechterung der bekannten Schichten bei Behandlungen unter oxidierenden Bedingungen ist analytisch festgestellt worden, dass die bekannten Schichten Chlor enthalten und man geht deshalb davon aus, dass das Chlor für die Bildung der Unterhöhlungen verantwortlich ist. Bei den sich an diese Untersuchungen anschliessenden Bemühungen, $SiO_2$-Filme zu erzeugen, welche in ihren Eigenschaften, insbesondere ihrer Gleichmässigkeit gegenüber Behandlungen unter oxidierenden Bedingungen, resistent sind, wurde deshalb nach einem Verfahren gesucht, mit

welchem nicht nur SiO$_2$-Filme hoher Qualität erzeugt werden können, sondern auch der schädliche Einfluss des Chlors ausgeschaltet wird. Mit dem erfindungsgemässen Verfahren lassen sich nicht nur Substratoberflächen mit SiO$_2$-Filmen bedecken, vielmehr lässt sich das Verfahren auch dazu verwenden, um Gräben, Kerben und sonstige Vertiefungen in einem Substrat mit Siliciumdioxid zu füllen. Solche mit SiO$_2$ gefüllten Kerben können beispielsweise dazu dienen, in Siliciumsubstraten zu integrierten Schaltungen gehörende passive und aktive Bauteile voneinander zu isolieren.

Die einfache Modifikation des bekannten Verfahrens zur Herstellung von SiO$_2$-Filmen gemäss dem Patentanspruch 1 verhindert eine Reaktion des aufgebrachten SiO$_2$-Films mit dem Substrat bei Behandlungen unter oxidierenden Bedingungen oberhalb 900 °C und damit die Ausbildung von Bläschen und Erhebungen und das Abblättern von SiO$_2$. Offenbar verhindert der Sauerstoffzusatz einen Einbau von Chlor in den aufwachsenden SiO$_2$-Film. Günstige Aufwachsgeschwindigkeiten des SiO$_2$-Films liegen dabei im Bereich zwischen etwa 2,5 und 50 nm/min.

Die genannte Reaktion des aufgebrachten SiO$_2$-Films verhindert auch das Verfahren gemäss dem Patentanspruch 5. Bei diesem Verfahren wird zwar der Einbau von Chlor in den aufwachsenden SiO$_2$-Filmen nicht unterbunden, jedoch verhindert die Siliciumnitridschicht, dass Chlor bzw. ein anderer reaktiver Stoff aus dem SiO$_2$-Film mit dem Substrat in Kontakt kommt. Die Si$_3$N$_4$-Schicht kann zwischen etwa 5 und etwa 300 nm dick gemacht werden (bei einer Dicke des SiO$_2$-Films zwischen etwa 100 und etwa 10 000 nm). Si$_3$N$_4$-Schichten, welche dicker als 300 nm sind, können Stressprobleme verursachen.

In der deutschen Offenlegungsschrift 1 717 205 wird zwar die Erzeugung einer aus einer SiO$_2$- und einer Si$_3$N$_4$-Schicht bestehenden Struktur auf einem Halbleiterkörper mittels chemischen Niederschlagens aus der Dampfphase beschrieben, jedoch enthält das Gasgemisch zur Erzeugung des SiO$_2$ kein oxidierendes Stickstoffoxid, deckt die Si$_3$N$_4$-Schicht die SiO$_2$-Schicht ab und nicht umgekehrt und ausserdem sind in der Offenlegungsschrift nicht die mit in der SiO$_2$-Schicht eingebautem Chlor verbundenen Probleme angesprochen.

Weitere vorteilhafte Ausgestaltungen des erfindungsgemässen Verfahrens ergeben sich aus den Unteransprüchen.

Die Erfindung wird anhand von durch Zeichnungen erläuterten Ausführungsbeispielen beschrieben.

Es zeigen:

Fign. 1 und 2 Photographien von erodierten, bei niedrigem Druck mittels chemischen Niederschlagens aus der Dampfphase abgeschiedenen und dann oxidierend behandelten Siliciumdioxid-Filmen in 216facher Vergrösserung,

Fig. 3 eine Phtographie eines Siliciumdioxid-Films in 216facher Vergrösserung, welcher nicht erodiert ist, und welcher gemäss einem der erfindungsgemässen Verfahren erzeugt und dann oxidierend behandelt worden ist,

Fig. 4 eine schematische Querschnittsdarstellung, welche das Unterhöhlungsproblem illustriert,

Fign. 5 und 6 in schematischer Darstellung Querschnitte durch die Öfen für das chemische Niederschlagen aus der Dampfphase gemäss der Erfindung, wobei auch die Gaseinlässe abgebildet sind,

Fign. 7 und 8 die Strukturen, welche bei der Durchführung einer der Ausführungsformen des erfindungsgemässen Verfahrens erzeugt werden, und welche Siliciumdioxid-Filme aufweisen, von denen keine Partikel bei nachfolgenden Oxidationen abblättern.

Siliciumdioxid-Filme, welche mittels chemischen Niederschlagens aus der Dampfphase bei niedrigem Druck erzeugt worden sind, bei welchen eine Gasphasenreaktion zwischen Distickstoffoxid und Chlorsilanen, wobei Dichlorsilan besonders bevorzugt wird, stattfindet, werden bei einem bei 1050 °C durchgeführten Oxidationszyklus in einer Chlorwasserstoff-Sauerstoffatmosphäre unterhöhlt. Diese Unterhöhlung geht soweit, dass tatsächlich ein Abblättern des SiO$_2$-Films stattfindet. Die Eigenschaften der Filme nach dem Abscheiden erscheinen ausgezeichnet. Die Oberflächen sind planar und ohne jede Struktur, der Brechungsindex liegt bei 1,456 und das Infrarotspektrum ist identisch mit demjenigen von auf anderem Weg hergestellten SiO$_2$-Filmen hoher Qualität. Die Ätzgeschwindigkeit in 5:1 gepufferter Flusssäure ist etwas kleiner als die von anderen, mittels chemischen Niederschlagens aus der Dampfphase erzeugten SiO$_2$-Filmen hoher Qualität, und in einer Brenzkatechinlösung wird kein chemischer Angriff beobachtet, wenn das Material als Maskenmaterial benutzt wird. Die Porendichte (pinhole density), welche mittels der Methode des Metallkondensator-Oxid-Durchbruchs (Metal Capacitor Oxide Breakdown) durchgeführt wurde, ergab einen Wert von Null.

Nach dem Abscheiden wurden die Filme 30 Minuten lang bei 1000 °C und 60 Minuten lang bei 1100 °C in einer Argonatmosphäre getempert. Das Tempern hatte auf keine der Filmeigenschaften irgendeinen Einfluss. Die Oberflächen blieben strukturlos, und die Dicken und der Brechungsindizes blieben unverändert, so dass man annehmen konnte, dass das SiO$_2$ in einem verdichteten Zustand abgeschieden wird. Dasselbe Ergebnis hatte ein 30 Minuten dauerndes Tempern bei 1150 °C in einer Wasserstoffatmosphäre.

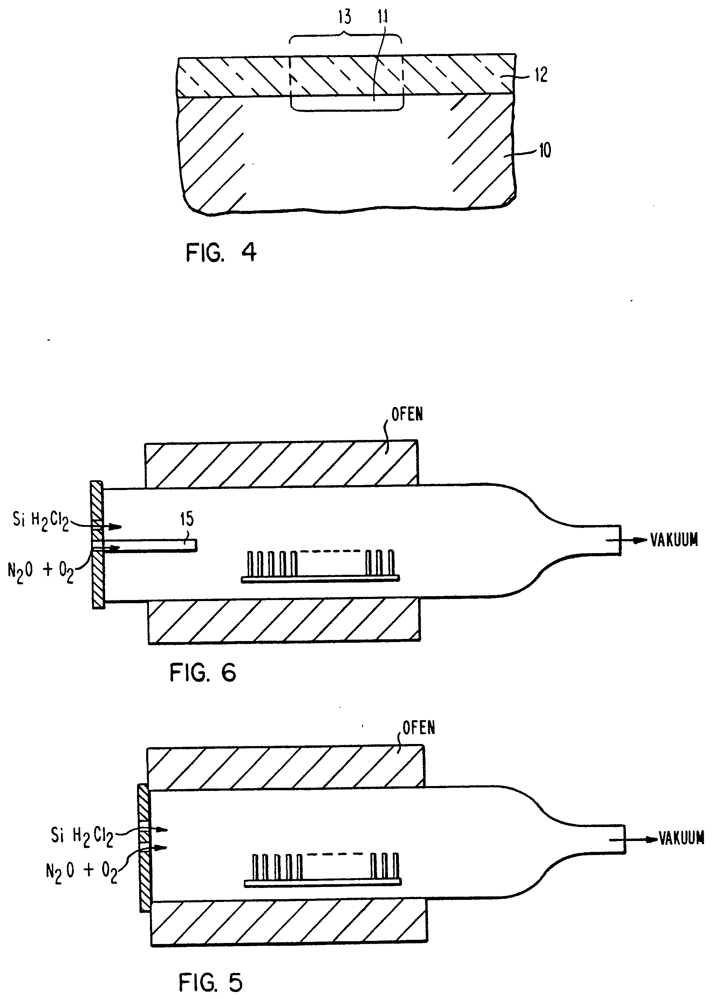

Es wurde aber gefunden, dass der SiO$_2$-Film bei hohen Temperaturen in der Gegenwart von Chlorwasserstoff, Wasser und Sauerstoff reagierte. Das Ergebnis der Reaktion variiert zwischen einer hohen Dichte von kleinen Erhebungen und einem Abblättern des Films. Die Fig. 4 erläutert das Unterhöhlungsproblem, wobei das Siliciumsubstrat 10 unter Bildung einer Öffnung 11 an der Grenzfläche zwischen dem Siliciumdioxid-Film 12 und dem

Siliciumsubstrat 10 angegriffen wird. Der Bereich 13 des Siliciumdioxid-Films oberhalb der Öffnung 11 kann ausbrechen. Das Unterhöhlungsproblem tritt bei Oxidationen in einer Sauerstoffatmosphäre, welcher 2% Chlorwasserstoff (2% Hydrogenchloride-$O_2$-Oxidation) zugemischt ist, bei 1050°C, aber nicht bei 850°C, auf. Oxidationen in trockenem Sauerstoff bei 1100°C bewirken nach 60 Minuten eine Erhebungsbildung hoher Dichte auf den Filmen. Eine 220 Minuten dauernde Behandlung erhöht die Dichte nicht mehr. Eine Erhebungsbildung gleicher Dichte tritt auf bei nassen Oxidationen bei 1000°C. Eine Erhöhung der Temperatur bei der nassen Oxidation auf 1100°C bewirkt eine vollständige Unterhöhlung. Ein Trokken-Nass-Trocken-Oxidationszyklus, bei dem bei 1100°C Filme, welche unter unterschiedlichen Bedingungen abgeschieden worden waren, 5 Minuten einer trockenen Sauerstoffatmosphäre, 10 Minuten einer nassen, oxidierenden Atmosphäre und noch einmal 5 Minuten einer trockenen Sauerstoffatmosphäre ausgesetzt werden, wurde als Testverfahren eingesetzt, um die einzelnen Filme charakterisieren zu können.

Filme, welche in Argon bei 1100°C 60 Minuten lang, in Sauerstoff bei 1100°C 220 Minuten lang bzw. in Wasserstoff bei 1150°C 30 Minuten lang getempert worden waren, wurden getestet. Diese Verfahren brachten keine feststellbaren Verbesserungen. Zu den Prozessparametern, welche beim Aufwachsen variiert wurden, gehören die Aufwachsgeschwindigkeit, welche zwischen 2,5 und 22 nm/Min. variiert wurde, das $N_2O:SiH_2Cl_2$ Verhältnis, welches zwischen 10:1 und 3:1 variiert wurde, der Druck im System, welcher zwischen 399 µbar und 1067 µbar variiert wurde, und die Temperatur, welche zwischen 890 und 940°C variiert wurde. Von diesen Parametern hat nur die Temperatur einen Einfluss auf die Ergebnisse. Es ist festgestellt worden, dass das Problem bei Abscheidungen bei niedrigen Temperaturen stärker von der Dicke des Films abhängt. Bei Dicken unter 150 nm erfolgt eine Blasenbildung. Bei Dicken zwischen ungefähr 150 und ungefähr 250 nm erhöht sich die Dichte dieser Blasen, so dass sich schliesslich Platten bilden, welche zum Substrat orientiert zu sein scheinen. Bei Dicken oberhalb 250 nm werden das Unterhöhlen und das Abblättern beobachtet. Mittels eines rasternden Elektronenmikroskops (SEM) wurde festgestellt, dass die Erhebungen und Platten wahrscheinlich auf einen chemischen Angriff, dem das Siliciumsubstrat ausgesetzt wird, zurückzuführen ist. Die Erhebungen und Platten sind Ätzgrübchen geringer Tiefe im Siliciumsubstrat.

Es wird angenommen, dass das Problem durch den Einschluss von Chlor in den abgeschiedenen $SiO_2$-Filmen verursacht wird. Das Chlor könnte als Bestandteil des $SiO_xCl_y$, welches bei der unvollständigen Oxidation von Chlorsilan, wie z.B. dem Dichlorsilan ($SiH_2Cl_2$), entsteht, in den Film eingebaut sein.

Eine physikalische Analyse der abgeschiedenen $SiO_2$-Filme mittels Auger- und Raman-Spektroskopie bestätigten die Anwesenheit von Chlor.

Ein klarer Hinweis auf Chlor wurde an der $SiO_2$-Si-Grenzfläche gefunden, aber eine genaue Konzentrationsbestimmung konnte mittels der Auger-Methode nicht durchgeführt werden. Auf der anderen Seite wurde mittels der Raman-Spektroskopie in den untersuchten Proben ein durchschnittlicher Chlorgehalt von 2,7% über die Schichtdicke des $SiO_2$-Films nach dem Abscheiden bestimmt.

Eine Lösung der Aufgabe, welche sie sich gestellt hatten, suchten die Erfinder in zwei Richtungen.

Es wurden Versuche unternommen, um die ablaufenden Reaktionen so zu ändern, dass ein Einbau von Chlor in die Filme ausgeschlossen wird. Um die Bildung von Chlorwasserstoff und damit das Aufbrechen der Si-Cl-Bindung zu fördern, wurde Wasserstoff in die Reaktionsmischung eingeführt. Flüsse von 5 Liter Wasserstoff pro Minute hatten jedoch keinen Einfluss auf die Verschlechterung der Filme bei nachfolgenden Oxidationen. Anschliessend wurde ein Zusatz von Sauerstoff mit einer Flussrate von 100 cm³/Min. versucht. Die resultierenden Filme hatten einen Schleier, waren in der Dicke uneinheitlich und hatten einen Brechungsindex von 1,33. Bei der Reoxidation jedoch wurde keine Tendenz zur Unterhöhlungsbildung festgestellt und der Brechungsindex stieg auf 1,445 an. Während des Niederschlagens hatte eine beachtliche Gasphasenreaktion stattgefunden. Wurde der Sauerstofffluss auf 25 cm³/Min. reduziert, erhöhte sich der Brechungsindex der abgeschiedenen Filme auf 1,408 und stieg bei der Reoxidation weiter auf 1,454. Eine weitere Reduzierung des Sauerstoffflusses erzeugte klare Filme mit nur sehr geringen Dickenschwankungen, welche keine Tendenz zur Unterhöhlung des Siliciumsubstrats zeigten. Der wirkungsvolle Sauerstoffbereich, um stabile $SiO_2$-Filme im verdichteten Zustand zu erzeugen, liegt zwischen ungefähr 0,25 und ungefähr 10%. Bei einer Sauerstoffzugabe von oberhalb 10% verschlechtert sich die Dickeneinheitlichkeit der Filme und die Wachstumsgeschwindigkeit des $SiO_2$ stark. Die optimale Sauerstoffzugabe bezogen auf den Brechungsindex, den Chlorgehalt und die Dickeneinheitlichkeit der Filme – liegt zwischen 0,25 und 2,5%. Als optimaler Temperaturbereich, um den Sauerstoff in die Reaktion einzuführen, wird der Bereich zwischen 500 und 1000°C angesehen. In diesem Bereich verringert sich die Gasphasenreaktion zwischen Chlorsilan und Sauerstoff auf ein Minimum.

Brauchbare Temperaturen für das Abscheiden von $SiO_2$ liegt bei der Verwendung von $SiH_2Cl_2$ bei 800 bis 1050°C, bei der Verwendung von $SiHCl_3$ zwischen 900 und 1100°C und bei der Verwendung von $SiCl_4$ zwischen 950 und 1200°C. Das Stickstoffoxid dissoziiert bei niedrigen Drücken unterhalb 800°C nur wenig, deshalb müssen die Reaktionstemperaturen zum Aufwachsen des $SiO_2$ oberhalb dieser Temperatur liegen.

Die Verbesserung des bei niedrigem Druck in einer Chlorsilan und Distickstoffoxid enthaltenden Atmosphäre ablaufenden Prozesses durch den Zusatz von Sauerstoff erlaubt es, Siliciumdioxid-Filme hoher Qualität abzuscheiden, deren Dicken im Bereich zwischen 100 und 10 000 nm liegen. Die Aufwachsgeschwindigkeit liegt zwischen 2,5 und 50 nm/Min. Das Verfahren kann dazu verwendet werden, um Siliciumdioxid-Filme auf einer flachen Oberfläche aufzuwachsen oder um Kerben oder Öffnungen in einem Körper, wie z.B. einem Siliciumhalbleitersubstrat, mit Siliciumdioxid zu füllen. Die gefüllten Kerben in einem Siliciumhalbleiterkörper können als dielektrische Isolation zwischen Bereichen von einkristallinem Silicium dienen.

Die folgenden 2 Beispiele sollen das eine erfindungsgemässe Verfahren noch genauer erläutern. Es sei aber klargestellt, dass der Fachmann bei der Durchführung dieser Ausführungsform des erfindungsgemässen Verfahrens nicht auf die Anwendung der in den Beispielen genannten Prozessparameter festgelegt ist.

Beispiel 1

Sauerstoff wurde in die Distickstoffoxid-Zuleitung zu dem in der Fig. 5 gezeigten Ofen für das chemische Niederschlagen aus der Dampfphase von Siliciumdioxid eingespeist und zwar bei voneinander unabhängigen Prozessabläufen in Mengen von 1, 5, 10, 15, 25 bzw. 100 cm³/Min. Die anderen Prozessparameter waren bei allen Prozessabläufen dieselben und zwar:

70 cm³ $SiH_2Cl_2$/Min.
300 cm³ $N_2O$/Min.
Reaktionstemperatur ungefähr 920 °C
Einlasstemperatur der Gase 600 °C
Druck: 973 µbar.

In der folgenden Tabelle sind für die bei den verschiedenen Prozessabläufen zugegebenen Sauerstoffmengen der Volumanteil des Sauerstoffs in der Reaktionsgasmischung und der Brechungsindex und das Aussehen des jeweils erzeugten $SiO_2$-Films aufgelistet.

| $O_2$-Zugabe | $O_2$-Vol.%-Anteil in der aus $N_2O$, $O_2$ und $SiH_2Cl_2$ bestehenden Reaktionsgasmischung | Brechungs-index | Aussehen des $SiO_2$-Films |
|---|---|---|---|
| 1 cm³/Min. | 0,27 | 1,459 | keine Unterhöhl. kein Schleier |
| 5 cm³/Min. | 1,3 | 1,452 | keine Unterhöhl. kein Schleier |
| 10 cm³/Min. | 2,65 | 1,45 | keine Unterhöhl. kein Schleier |
| 15 cm³/Min. | 3,9 | 1,435 | keine Unterhöhl. Schleier |
| 25 cm³/Min. | 6,3 | 1,403 | keine Unterhöhl. Schleier |
| 100 cm³/Min. | 21,5 | 1,33 | keine Unterhöhl. Schleier |

Die Unterhöhlung wurde bestimmt mittels der Anwendung eines 10 Minuten dauernden, in Dampf bei 1100 °C ablaufenden Temperns. Dieses Tempern neigt dazu, die abgeschiedenen Filme, welche einen Schleier enthalten, zu verdichten. Der Schleier ist auf eine Gasphasenreaktion zurückzuführen, welche $SiO_2$-Teilchen produziert, welche den Schleier verursachen, wofür der bei der Verdichtung angestiegene Brechungsindex spricht. Das $SiO_2$ mit einem Brechungsindex von 1,33 hat dank der Anwesenheit dieser diskreten $SiO_2$-Teilchen viele Lunker.

Beispiel 2

In voneinander getrennten Prozessabläufen wurde Sauerstoff in das $N_2O$-Zuleitungsrohr zu dem in der Fig. 6 gezeigten Ofen für das Herstellen von Siliciumdioxid mittels chemischen Niederschlagens aus der Dampfphase in Mengen von 5, 15, 25, 35 bzw. 45 cm³/Min. eingespeist. Es wurden zwei Serien von Experimenten durchgeführt. Bei der ersten Serie wurde das $N_2O/O_2$-Gemisch am vorderen Ende des Reaktors, wo die Wandtemperatur ungefähr 200 °C beträgt, in den Ofen eingeleitet. Bei der zweiten Serie wurde das $N_2O/O_2$-Gemisch mittels eines Injektionsrohrs 15 an einer Stelle in die vordere Ofenzone eingeleitet, an welcher die Temperatur ungefähr 850 °C betrug. Alle anderen Prozessparameter waren dieselben wie im Beispiel 1.

In den folgenden Tabellen sind für die bei den beiden Serien von Experimenten zugegebenen Sauerstoffmengen der Anteil des Sauerstoffs in der Reaktionsgasmischung und Angaben darüber, ob eine Unterhöhlung des jeweils erzeugten $SiO_2$-Films auftrat und ob dieser einen Schleier aufwies oder nicht, aufgelistet.

Serie 1

| $O_2$-Zugabe cm³/Min. | $O_2$-Vol.%-Anteil in der aus $N_2O$, $O_2$ u. $SiH_2Cl_2$ bestehenden Reaktions- gasmischung | Bemerkungen | Aussehen des $SiO_2$-Films |
|---|---|---|---|
| 5 | 1,3 | Unterhöhlung | kein Schleier |
| 15 | 3,9 | Unterhöhlung | Schleier |
| 25 | 6,3 | Unterhöhlung | Schleier |
| 35 | 8,6 | Unterhöhlung | Schleier |
| 45 | 10,8 | Unterhöhlung | Schleier |

Serie 2

| $O_2$-Zugabe cm³/Min. | $O_2$-Vol.%-Anteil in der aus $N_2O$, $O_2$ u. $SiH_2Cl_2$ bestehenden Reaktions- gasmischung | Bemerkungen | Aussehen des $SiO_2$-Films |
|---|---|---|---|
| 5 | 1,3 | Unterhöhlung | kein Schleier |
| 15 | 3,9 | geringe Unter- höhlung | kein Schleier |
| 25 | 6,3 | keine Unter- höhlung | kein Schleier |
| 35 | 8,6 | keine Unter- höhlung | kein Schleier |
| 45 | 10,8 | keine Unter- höhlung | kein Schleier |

Die Fig. 1 zeigt eine Photographie der 216 mal vergrösserten Oberfläche des $SiO_2$-Films, welcher mit einer Gasmischung, welche 1,3% Sauerstoff enthielt, erzeugt worden war. Fig. 2 ist eine Photographie der 216 mal vergrösserten Oberfläche des $SiO_2$-Films, bei dessen Herstellung die Reaktionsgasmischung 3,9% $O_2$ enthielt. Die Fig. 3 zeigt eine Photographie der 216 mal vergrösserten Oberfläche des $SiO_2$-Films, bei dessen Herstellung in der Reaktionsgasmischung 8,6% Sauerstoff enthalten waren. Das Eindringen des $N_2O/O_2$-Gemischs bei hohen Temperaturen hat eindeutig einen günstigen Effekt bei der Verminderung der Gasphasenreaktion zwischen $SiH_2Cl_2$ und $O_2$, was zur Folge hat, dass der Niederschlag keinen Schleier aufweist. Diese Art des Einbringens der Mischung verbessert auch die Effektivität der Verminderung des Chlorgehalts in den Filmen nach dem Aufbringen, so dass das Unterhöhlungsproblem eliminiert wird, wenn der Sauerstoffanteil in der Reaktionsgasmischung grösser als 4 Vol.% ist.

Die im Rahmen des Beispiels 1 durchgeführten Versuche fanden in einem kürzeren Reaktionsrohr, wie es die Fig. 5 wiedergibt, statt, so dass die $SiH_2Cl_2/N_2O/O_2$-Mischung in keinem Augenblick einer Temperatur, welche unterhalb ungefähr 600 °C lag, ausgesetzt war. Unter diesen Bedingungen ist offenbar sogar noch weniger Sauerstoff notwendig, um eine vollständige Entfernung von Chlor aus dem niedergeschlagenen Film zu erreichen.

Es wurden ausserdem Versuche unternommen, um die gestellte Aufgabe auch zu lösen, indem eine schützende Barriere gegen den Angriff des Siliciumsubstrats durch das Chlor errichtet wurde. Polykristallines Silicium als Material für die Barriere wurde ausgeschlossen, da das Problem der Unterhöhlung zunächst an polykristallinem Silicium beobachtet worden war. Es wurde gefunden, dass thermisch aufgewachsenes $SiO_2$ und mittels chemischen Niederschlagens aus der Dampfphase aufgebrachtes $SiO_2$ nur dann etwas wirksam waren, wenn die Barrierendicke sehr gross bzw. ungefähr gleich der Dicke des bei niedrigem Druck chemisch niedergeschlagenen $SiO_2$-Films war.

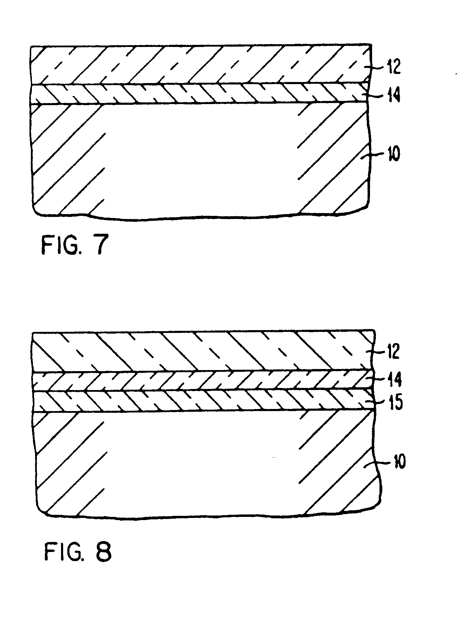

Es wurde festgestellt, dass Siliciumnitrid eine wirkungsvolle Barriere darstellt, wenn es in Dicken grösser 5 nm entweder – wie es die Fig. 7 zeigt – direkt auf dem Silicium oder – wie es die Fig. 8 zeigt – auf einer Siliciumdioxid-Puffer-Schicht abgeschieden wird. Auf dieser Feststellung beruht das andere erfindungsgemässe Verfahren. Die bevorzugte Dicke der Siliciumnitridschicht 14 liegt zwischen ungefähr 10 und etwa 50 nm. Die Siliciumnitridschicht kann bis zu 300 nm dick sein. Dicken oberhalb 300 nm verursachen Spannungsprobleme. $SiO_2$-Filme, welche bei niedrigem Druck mittels chemischen Niederschlagens aus der Dampfphase in Dicken bis zu 2 µm aufgebracht worden sind, wurden in Dampf bei 1100 °C 60 Minuten lang einer oxidierenden Atmosphäre ausgesetzt, ohne dass eine Unterhöhlung – ausser an den Stellen, an welchen das Siliciumnitrid Poren aufwies – auftrat.

Das Siliciumnitrid wird bevorzugt bei einem Druck von 1 Atmosphäre unter Anwendung einer Mischung aus $SiH_4$ und $NH_3$ bei einer Niederschlagstemperatur, welche im Bereich zwischen ungefähr 700 und ungefähr 1000 °C liegt, niedergeschlagen. Die Unterschicht 15 aus Siliciumdioxid wird bevorzugt mittels thermischer Oxidation des Siliciumsubstrats bei 1000 °C in Dampf erzeugt. Die Dicke des $SiO_2$ liegt zwischen ungefähr 10 und ungefähr 500 nm.

Die Anwendung der Siliciumnitridschicht erlaubt es, Siliciumdioxid-Filme hoher Qualität mit Dicken im Bereich zwischen 100 und 10 000 nm aufzubringen.

Die folgenden Beispiele sollen dazu dienen, die Ausführungsform des erfindungsgemässen Verfahrens, bei welcher eine Siliciumnitridschicht Anwendung findet, noch deutlicher zu machen. Es sei aber klargestellt, dass der Fachmann bei der Durchführung dieser Ausführungsform des erfindungsgemässen Verfahrens nicht auf die Anwendung der in den Beispielen genannten Prozessparameter festgelegt ist.

Beispiel 3

Siliciumnitrid wurde auf einer Reihe von Plättchen abgeschieden. Die Reaktion wurde in einer Atmosphäre, welche $SiH_4$, $NH_3$ und Stickstoff (als Trägergas) enthielt. Die Aufwachstemperatur lag bei 800 °C und die Aufwachsgeschwindigkeit bei ungefähr 10 nm/Min.

Auf die Plättchen, auf welche direkt auf das Siliciumsubstrat $Si_3N_4$-Schichten aufgebracht worden waren, deren Dicken 0, 2, 5, 5, 10, 20 bzw. 50 nm betrugen, wurden in einem Hochtemperatursystem mittels chemischen Niederschlagens aus der Dampfphase bei niedrigem Druck 1 µm dicke $SiO_2$-Filme aufgebracht. Diese Plättchen wurden dann in Dampf bei 1100 °C getempert, um die Wirksamkeit der $Si_3N_4$-Barriere zu überprüfen.

Bei allen Plättchen, auf denen eine $Si_3N_4$-Schicht aufgebracht worden war, welche dicker als 5 nm war, war die Barriere 100%ig effektiv im Eliminieren der Unterhöhlungen.

Beispiel 4

Eine Reihe von Plättchen, welche von derselben Art waren, wie diejenigen, welche im Beispiel 3 benutzt worden sind, wurden – mit einer Ausnahme – in derselben Weise wie die in Beispiel 3 benutzten Plättchen behandelt. Die Ausnahme bestand darin, dass eine 100 nm dicke thermisch gewachsene $SiO_2$-Schicht zwischen dem Siliciumsubstrat und der $Si_3N_4$-Barriere erzeugt wurde. Die Ergebnisse waren dieselben wie im Beispiel 3. Das Siliciumoxid hatte keinen Einfluss auf die $Si_3N_4$-Barrierenschicht.

**Patentansprüche**

1. Verfahren zum Aufbringen eines Siliciumdioxidfilms (12) auf ein Substrat (10) mittels chemischen Niederschlagens aus der Dampfphase in der heissen Zone eines Ofens bei Temperaturen oberhalb etwa 800 °C und bei Drücken > 6,66 mbar, bei welchem ein Chlorsilan mit einem oxidierenden Stickstoffoxid zur Reaktion gebracht wird, dadurch gekennzeichnet, dass zusätzlich Sauerstoff in Mengen zwischen 0,25 und etwa 10 Vol.% bezogen auf die Gesamtmenge der reaktiven Gase zugemischt wird, wobei der Sauerstoff bei Temperaturen zwischen 500 und 1000 °C mit dem Chlorsilan vermischt wird und wobei die mindestens erforderliche Sauerstoffmenge in der Weise von der Temperatur, bei welcher der Sauerstoff mit dem Chlorsilan vermischt wird, abhängt, dass, wenn als Chlorsilan Dichlorsilan verwendet wird bei einer Temperatur von 600 °C diese Sauerstoffmenge bei 0,27 Vol.% und bei einer Temperatur von 850 °C bei etwa 4 Vol.% jeweils bezogen auf die Gesamtmenge der reaktiven Gase liegt.

2. Verfahren nach Anspruch 1, dadurch gekennzeichnet, dass als Chlorsilan Dichlorsilan verwendet wird und dass $O_2$ in einer Menge zwischen 0,27 und 3,9 Vol.% bezogen auf die Gesamtmenge der reaktiven Gase in einem Bereich der heissen Zone, in dem eine Temperatur von ungefähr 600 °C herrscht, mit dem Dichlorsilan vereinigt wird.

3. Verfahren nach einem der Ansprüche 1 oder 2, dadurch gekennzeichnet, dass die $SiO_2$-Schicht (12) mit einer Geschwindigkeit von 2,5 bis 50 nm pro Minute aufgewachsen wird.

4. Verfahren zum Aufbringen eines Siliciumdioxid-Films (12) auf ein Substrat (10) mittels chemischen Niederschlagens aus der Dampfphase in der heissen Zone eines Ofens bei Temperaturen oberhalb etwa 800 °C und bei Drücken < 6,66 mbar, bei welchem ein Chlorsilan mit einem oxidierenden Stickstoffoxid zur Reaktion gebracht wird, dadurch gekennzeichnet, dass auf dem Substrat (10) vor dem Aufbringen des $SiO_2$-Films (12) eine mindestens 5 nm dicke $Si_3N_4$-Schicht (14) abgeschieden wird.

5. Verfahren nach Anspruch 4, dadurch gekennzeichnet, dass die $Si_3N_4$-Schicht (14) zwischen ungefähr 5 und ungefähr 300 nm und der $SiO_2$-Film (12) zwischen etwa 100 und etwa 10 000 nm dick gemacht werden.

6. Verfahren nach Anspruch 4 oder 5, dadurch gekennzeichnet, dass die $Si_3N_4$-Schicht (14) mittels chemischen Niederschlagens aus der Dampfphase in einer $SiH_4$ und $NH_3$ enthaltenden Atmosphäre bei Temperaturen zwischen etwa 700 und etwa 1000 °C erzeugt wird.

7. Verfahren nach einem der Ansprüche 1 bis 6, dadurch gekennzeichnet, dass als Chlorsilan Dichlorsilan verwendet wird und bei einer Reaktionstemperatur zwischen etwa 800 und etwa 1050 °C gearbeitet wird.

8. Verfahren nach einem der Ansprüche 1 bis 7, dadurch gekennzeichnet, dass der $SiO_2$-Film (12)

auf einem Substrat (10) aus Silicium aufgebracht wird.

## Claims

1. Method of applying a silicon dioxide film (12) on a substrate (10) by means of chemical vapor deposition in the hot zone of a furnace at temperatures of more than approximately 800 °C, and pressures >6.66 mbar, where a chlorosilane is made to react with a nitrous oxide, characterized in that additional oxygen quantities ranging between 0.25 and approximately 10 Vol.% referring to the total of reactive gases are admixed, the oxygen being mixed at temperatures between 500 and 1000 °C with the chlorosilane, and the minimum oxygen quantity required depending on the temperature at which the oxygen is mixed with the chlorosilane in such a manner that, if dichlorosilane is used as chlorosilane at a temperature of 600 °C, this oxygen quantity is around 0.27 Vol.%, and with a temperature of 850 °C around 4 Vol.%, each time referring to the total amount of reactive gases.

2. Method as claimed in claim 1, characterized in that dichlorosilane is used as chlorosilane, and $O_2$ is combined with the dichlorosilane in a quantity between 0.27 and 3.9 Vol.% referring to the total amount of reactive gases, in a region of the hot zone which has a temperature of approximately 600 °C.

3. Method as claimed in any one of claims 1 or 2, characterized in that the $SiO_2$ layer (12) is grown with a speed of 2.5 to 50 nm per minute.

4. Method of applying a silicon dioxide film (12) on a substrate (10) by means of chemical vapor deposition in the hot zone of a furnace at temperatures of more than approximately 800 °C and pressures >6.66 mbar, where a chlorosilane is made to react with an oxidizing nitrous oxide, characterized in that prior to the application of the $SiO_2$ film (12) an $Si_3N_4$ layer (14) of at least 5 nm thickness is deposited on the substrate (10).

5. Method as claimed in claim 4, characterized in that the $Si_3N_4$ layer (14) is made with a thickness between approximately 5 and approximately 300 nm, and the $SiO_2$ film (12) with a thickness between approximately 100 and approximately 10 000 nm.

6. Method as claimed in any one of claims 4 or 5, characterized in that the $Si_3N_4$ layer (14) is produced by means of chemical vapor deposition in an atmosphere containing $SiH_4$ and $NH_3$, at temperatures between approximately 700 and approximately 1000 °C.

7. Method as claimed in any one of claims 1 to 6, characterized in that dichlorosilane is used as chlorosilane, and operations take place at a reaction temperature between approximately 800 and approximately 1050 °C.

8. Method as claimed in any one of claims 1 to 7, characterized in that the $SiO_2$ film (12) is made on a silicon substrate (10).

## Revendications

1. Procédé pour appliquer une pellicule de silice (12) sur un support (10) par déposition chimique en phase vapeur dans la zone chaude d'un four à des températures supérieures à 800 °C environ et à des pressions supérieures à 6,66 mbar, dans lequel on fait réagir un chlorosilane avec un oxyde d'azote oxydant, caractérisé en ce que, on mélange en outre de l'oxygène en quantités de 0,25 à environ 10% en volume par rapport à la quantité totale des gaz réactifs, l'oxygène étant mélangé avec le chlorosilane à des températures de 500 à 1000 °C, et la quantité minimale nécessaire d'oxygène dépendant de la température à laquelle l'oxygène est mélangé avec le chlorosilane en ce que, lorsqu'on utilise en tant que chlorosilane le dichlorosilane, cette quantité d'oxygène est de 0,27% en volume à une température de 600 °C et d'environ 4% en volume à une température de 850 °C, dans les deux cas par rapport à la quantité totale des gaz réactifs.

2. Procédé selon la revendication 1, caractérisé en ce que le chlorosilane utilisé est le dichlorosilane et en ce que l'on combine avec le dichlorosilane $O_2$ en quantité de 0,27 à 3,9% en volume par rapport à la quantité totale des gaz réactifs dans une région de la zone chaude dans laquelle règne une température d'environ 600 °C.

3. Procédé selon l'une des revendications 1 ou 2, caractérisé en ce que la couche de $SiO_2$ (12) est déposée à une vitesse de 2,5 à 50 nm par mn.

4. Procédé pour appliquer une pellicule de silice (12) sur un support (10) par déposition chimique en phase vapeur dans la zone chaude d'un four à des températures supérieures à environ 800 °C et à des pressions inférieures à 6,66 mbar, dans lequel on fait réagir un chlorosilane avec un oxyde d'azote oxydant, caractérisé en ce que, on dépose sur le support (10) avant d'appliquer la pellicule de $SiO_2$ (12) une couche de $Si_3N_4$ (14) épaisse d'au moins 5 nm.

5. Procédé selon la revendication 4, caractérisé en ce que, on forme la couche de $Si_3N_4$ (14) à une épaisseur d'environ 5 à environ 300 nm et la pellicule de $SiO_2$ (12) à une épaisseur d'environ 100 à environ 10 000 nm.

6. Procédé selon la revendication 4 ou 5, caractérisé en ce que, la couche de $Si_3N_4$ (14) est formée par déposition chimique en phase vapeur dans une atmosphère contenant $SiH_4$ et $NH_3$ à des températures d'environ 700 à environ 1000 °C.

7. Procédé selon l'une des revendications 1 à 6, caractérisé en ce que, on utilise en tant que chlorosilane le dichlorosilane et on opère à une température de réaction d'environ 800 à environ 1050 °C.

8. Procédé selon l'une des revendications 1 à 7, caractérisé en ce que, la pellicule de $SiO_2$ (12) est déposée sur un support (10) en silicium.

FIG. 1

FIG. 2

FIG. 3

13  11

12

10

FIG. 4

OFEN

$Si H_2 Cl_2$

15

VAKUUM

$N_2 O + O_2$

FIG. 6

OFEN

$Si H_2 Cl_2$

VAKUUM

$N_2 O + O_2$

FIG. 5

FIG. 7

FIG. 8